# EUROPEAN PATENT APPLICATION

(11) **EP 2 495 735 A1**
(43) Date of publication of application: **05.09.2012**
(21) Application number: 10826866.5
(22) Date of filing: 29.10.2010
(51) Int. Cl.: H01B 12/06, C01G 1/00, C01G 3/00, H01B 13/00, H01F 6/06, H01F 36/00

(54) **LOW AC-LOSS MULTI-FILAMENT TYPE SUPERCONDUCTIVE WIRE MATERIAL, AND MANUFACTURING METHOD THEREOF**

(30) Priority: 30.10.2009 JP 2009250785
(71) Applicant: INTERNATIONAL SUPERCONDUCTIVITY TECHNOLOGY CENTER, Tokyo 135-0062 (JP); Fujikura, Ltd., Tokyo 135-8512 (JP)
(72) Inventor: MACHI Takato, Tokyo 135-0062 (JP); TOBITA Hiroshi, Tokyo 135-0062 (JP); TAKAHASHI Yasuo, Tokyo 135-0062 (JP); TANABE Keiichi, Tokyo 135-0062 (JP); IZUMI Teruo, Tokyo 135-0062 (JP)
(74) Representative: Hodsdon, Stephen James
(86) International application number: PCT/JP2010/069326
(87) International publication number: WO 2011/052736

(57) **Abstract**

A low AC-loss multi-filament superconducting wire material of the invention includes an elongated base material, an intermediate layer formed on the base material; a superconducting layer formed on the intermediate layer, and a metal stabilizing layer formed on the superconducting layer, wherein a plurality of grooves extending along a long direction of the base material is formed in parallel in a width direction of the base material, and reach the intermediate layer from the metal stabilizing layer via the superconducting layer to expose the intermediate layer; and a difference δd (= d1―d2) between a width d1 of the grooves at a lower part of the superconducting layer and a width d2 of the grooves at a lower part of the metal stabilizing layer is not more than 10 µm.

## Description

### TECHNICAL FIELD

The present invention relates to a multi-filament superconducting wire material that is highly effective in reducing AC-loss, and a manufacturing method therefor.
The present application claims priority on Japanese Patent Application No. 2009-250785, filed October 30, 2009, the content of which is incorporated herein by reference.

### BACKGROUND ART

Superconductors such as yttrium (Y) based oxide maintain a superconducting state in a range of conditions defined by the critical temperature, the critical current, and the critical magnetic field. On the other hand, superconductors, depending on their state, are known to suffer a phenomenon called quench, where one region of the superconductor enters the normal conductive state and generates heat during conduction of current, whereby the entire superconductor switches to a normal conductive state. When a quench phenomenon occurs, there is a possibility that the superconductor will burn out. To prevent this, a stabilizing layer (metal stabilizing layer) made from a metal with good heat conductivity and electrical conductivity is provided in contact with the superconducting layer in a complex structure. Due to the provision of this stabilizing layer, even if one region of the superconducting layer enters the normal conductive state during conduction of current, the current can be passed through (branched to) the stabilizing layer, stabilizing the characteristics of the superconducting layer.
To provide the stabilizing layer, a method of forming a stabilizing layer (silver stabilizing layer) of silver (Ag) by a physical method such as sputtering or deposition (see Patent Document 1), and a method of forming a stabilizing layer (copper stabilizing layer) of inexpensive copper (Cu) on a silver stabilizing layer via a solder between them (see Patent Document 2), have been disclosed.

When actually using a superconductor, such as in a cable or a transformer, the AC-loss must be reduced. It is known that, in a coil using a superconducting wire material, if grooves that reach the metal base material are formed in the superconducting layer, thereby thinning the superconducting layer by dividing it into a plurality of sections, the AC-loss can be reduced in inverse proportion to the number of divisions (see Patent Document 3 and Non-Patent Document 1). This thinning process is usually accomplished by laser irradiation, photolithography, etching, etc.
Thus, in a superconducting wire material including a metal stabilizing layer for stabilizing the superconducting layer and preventing burnout, it is important to make the superconducting layer thin in order to reduce AC-loss.

### PRIOR ART DOCUMENTS

### PATENT DOCUMENTS

[Patent Document 1]: Japanese Unexamined Patent Application, First Publication No. 2006-236652
[Patent Document 2]: Japanese Unexamined Patent Application, First Publication No. 2008-60074
[Patent Document 3]: Japanese Unexamined Patent Application, First Publication No. 2007-141688

### NON-PATENT DOCUMENTS[0005]

[Non-Patent Document 1]: Supercond. Soc. Technol., 20,822-826 (2007)

### DISCLOSURE OF THE INVENTION

### PROBLEMS TO BE SOLVED BY THE INVENTION

However, metal scraps from the metal stabilizing layer are liable to be created during the thinning process. For example, when thinning by laser irradiation, the laser irradiation creates molten scraps of metal called dross. Since the oxide superconducting layer formed on the substrate is thin, metal scraps from the metal stabilizing layer can get stuck in grooves between a plurality of superconducting layers divided during the thinning process, creating electrical connections between the superconducting layers. In this case, there is a problem that it becomes difficult to maintain resistance between the superconducting layers, creating coupling loss that leads to insufficient reduction of AC-loss.

The invention has been realized in view of the problems described above, and aims to provide a multi-filament superconducting wire material that is highly effective in reducing AC-loss. Another object is to provide a method for manufacturing a multi-filament superconducting wire material that is highly effective in reducing AC-loss with good productivity.

### MEANS FOR SOLVING THE PROBLEMS

To achieve these objects, the invention employs the followings.
(1) A low AC-loss multi-filament superconducting wire material according to an aspect of the present invention includes: an elongated base material; an intermediate layer formed on the base material; a superconducting layer formed on the intermediate layer; and a metal stabilizing layer formed on the superconducting layer. In the low AC-loss multi-filament superconducting wire material, a plurality of grooves extending along a long direction of the base material is formed in parallel in a width direction of the base material, and reach the intermediate layer from the metal stabilizing layer via the superconducting layer to expose the intermediate layer; and a difference δd (= d1―d2) between a width d1 of the grooves at a lower part of the superconducting layer and a width d2 of the grooves at a lower part of the metal stabilizing layer can be not more than 10 µm.
(2) The width d1 of the grooves at the lower part of the superconducting layer can be not less than 10 µm and not more than 500 µm.
(3) The resistance between the superconducting layer which is divided into a plurality of filament conductors by the plurality of grooves can be not less than 10⁵Ω/cm.
(4) The metal stabilizing layer can be an Ag layer.
(5) The metal stabilizing layer can contain an Ag layer, and a Cu layer laminated on the Ag layer.

(6) A method for manufacturing a low AC-loss multi-filament superconducting wire material according to another aspect of the present invention includes: laminating an intermediate layer, a superconducting layer, and a metal stabilizing layer in order on an elongated base material; masking a surface of the metal stabilizing layer to form a masking pattern, and by the masking pattern to provide an exposed part partially exposing the metal stabilizing layer in a plurality of thin lines in parallel in a width direction of the base material along a long direction of the base material; corroding the exposed part of the metal stabilizing layer in a strong alkaline solution to form first grooves along the long direction of the base material in the metal stabilizing layer, and thereby exposing the superconducting layer; and corroding the exposed superconducting layer in a strong acidic solution to form second grooves along the long direction of the base material, and thereby exposing the intermediate layer, wherein a difference δd (= d1―d2) between a width d1 of the second grooves at a lower part of the superconducting layer and a width d2 of the first grooves at a lower part of the metal stabilizing layer can be not more than 10 µm.
(7) In the method for manufacturing a low AC-loss multi-filament superconducting wire material, the metal stabilizing layer can be an Ag layer.
(8) In the method for manufacturing a low AC-loss multi-filament superconducting wire material, the metal stabilizing layer can contain an Ag layer, and a Cu layer laminated on the Ag layer.
(9) In the method for manufacturing a low AC-loss multi-filament superconducting wire material, the masking can be performed by affixing an adhesive tape.
(10) In the method for manufacturing a low AC-loss multi-filament superconducting wire material, the masking can be performed by varnish coating or spray coating.
(11) In the method for manufacturing a low AC-loss multi-filament superconducting wire material, the masking can be performed by affixing an adhesive tape, and irradiating a surface of the adhesive tape with a laser to form a masking pattern.
(12) In the method for manufacturing a low AC-loss multi-filament superconducting wire material, the masking can be performed by laser irradiating a surface which has been varnish coated or spray coated, to form a masking pattern.

(13) In the method for manufacturing a low AC-loss multi-filament superconducting wire material, the strong alkaline solution can be a mixed solution of hydrogen peroxide water and ammonia water.
(14) In the method for manufacturing a low AC-loss multi-filament superconducting wire material, the strong alkaline solution can be a mixed solution of hydrogen peroxide water and ammonia water at a weight ratio of hydrogen peroxide: ammonia = 13:1 to 1:2.
(15) In the method for manufacturing a low AC-loss multi-filament superconducting wire material, at least one of a type of the strong alkaline solution and a chemical composition of the strong alkaline solution can be adjusted in accordance with a type of metal constituting the metal stabilizing layer.
(16) In the method for manufacturing a low AC-loss multi-filament superconducting wire material, the strong acidic solution can be cerium ammonium nitrate solution.
(17) In the method for manufacturing a low AC-loss multi-filament superconducting wire material,while forming the masking pattern by the laser irradiation, at least one of a processing speed, which is a traveling speed of the superconducting wire material, and a laser irradiation output can be adjusted to keep the width of the grooves at the lower part of the superconducting layer not less than 10 µm and not more than 500 µm.

### EFFECTS OF THE INVENTION

The low AC-loss multi-filament superconducting wire material describe in (1) is divided into a plurality of filament conductors by the plurality of grooves extending along the long direction of the base material formed in the width direction of the base material, and the difference δd (= d1―d2) between the width d1 of the grooves at a lower part of the superconducting layer and the width d2 of the grooves at a lower part of the metal stabilizing layer is not more than 10 µm. This makes it possible to provide a superconducting wire material that is highly effective in reducing AC-loss.
In the method for manufacturing a low AC-loss multi-filament superconducting wire material described in (6), the surface of the metal stabilizing layer is masked and corroded in a strong alkaline solution to form the first grooves in the metal stabilizing layer, and this is corroded in a strong acidic solution to form the second grooves in the superconducting layer. According to this manufacturing method, the superconducting layer can be divided efficiently in a short period of time while removing residual pieces of Ag and the like. It is therefore possible to provide a manufacturing method that can manufacture a superconducting wire material that is highly effective in reducing AC-loss, with good productivity. Furthermore, by appropriately selecting the solution used in corroding the metal stabilizing layer and the solution used in corroding the superconducting layer, the grooves can be formed effectively and in a short period of time, and excessive removal of the superconducting layer known as over-etch can be prevented.

### BRIEF DESCRIPTION OF THE DRAWINGS

FIG. 1A is a schematic cross-sectional view of an example of a first embodiment of a low AC-loss multi-filament superconducting wire material according to the invention.
FIG. 1B is a partial enlarged cross-sectional view of FIG. 1A.
FIG. 1C is a partial perspective view of FIG. 1A.
FIG. 2A is an explanatory schematic process view of a method for manufacturing a low AC-loss multi-filament superconducting wire material of the invention, illustrating a horizontal cross-section of a superconducting wire material.
FIG. 2B is an explanatory schematic process view of a method for manufacturing a low AC-loss multi-filament superconducting wire material of the invention continuing from FIG. 2A, illustrating a horizontal cross-section of a superconducting wire material.
FIG. 2C is an explanatory schematic process view of the same method continuing from FIG. 2B, illustrating a horizontal cross-section of a superconducting wire material.
FIG. 2D is an explanatory schematic process view of the same method continuing from FIG. 2C, illustrating a horizontal cross-section of a superconducting wire material.
FIG. 2E is an explanatory schematic process view of the same method continuing from FIG. 2D, illustrating a horizontal cross-section of a superconducting wire material.
FIG. 3 is a schematic cross-sectional view of an example of a second embodiment of a low AC-loss multi-filament superconducting wire material according to the invention.
FIG. 4 is an exterior photograph of a multi-filament superconducting wire material of Example 1.
FIG. 5 is a magnetic flux observation photograph of a multi-filament superconducting wire material of Example 4.
FIG. 6 is a graph showing the width of an exposed part of a metal stabilizing layer formed when forming a masking pattern while changing the laser irradiation output and the traveling speed of a superconducting wire material.
FIG. 7A is a graph showing the relationship between the mixing ratio (volume ratio) of hydrogen peroxide water and ammonia water and the pH of that mixed solution in Example 7.
FIG. 7B is a graph showing the relationship between the mixing ratio (volume ratio) of hydrogen peroxide water and ammonia water and the etching time of a metal stabilizing layer by that mixed solution in Example 7.

### EMBODIMENTS FOR CARRYING OUT THE INVENTION

A low AC-loss multi-filament superconducting wire material according to an embodiment of the invention (hereinafter sometimes termed the superconducting wire material according to an embodiment of the invention) includes an elongated base material, an insulating intermediate layer formed on the base material, a superconducting layer formed on the intermediate layer, and a metal stabilizing layer formed on the superconducting layer. A plurality of grooves which is extending along the long direction of the base material is formed in parallel over the width direction of the base material. The grooves extend to the intermediate layer from the metal stabilizing layer via the superconducting layer, and expose the intermediate layer. The difference δd (= d1―d2) between the width d1 of the grooves at the lower part of the superconducting layer and the width d2 of the grooves at the lower part of the metal stabilizing layer is not more than 10 µm.
An embodiment of the invention will be explained in detail while referring to the drawings.

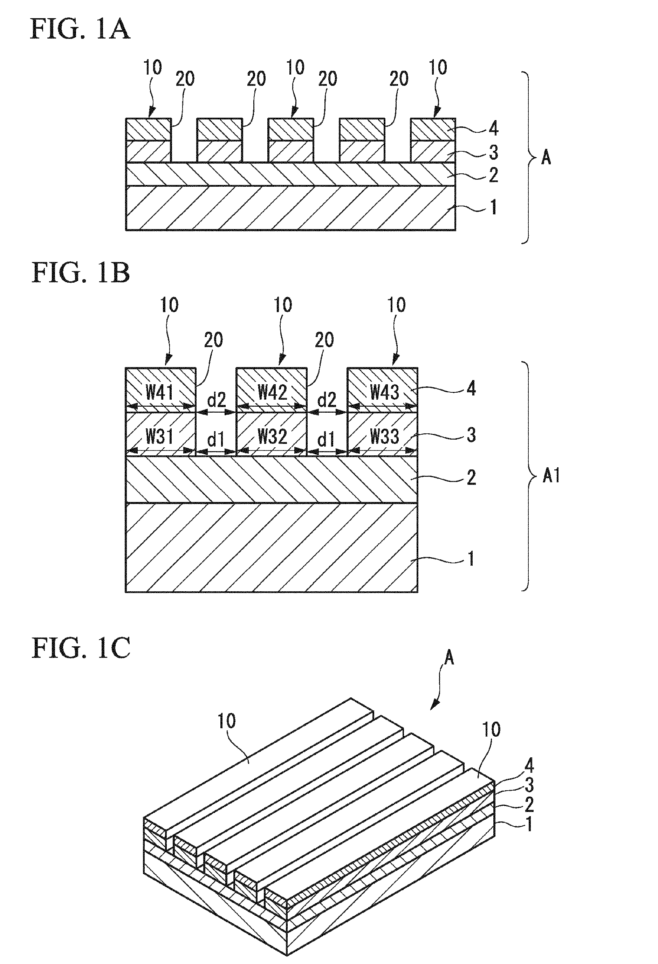

FIGS. 1A to 1C are schematic views of an example of a low AC-loss multi-filament superconducting wire material of a first embodiment according to the invention. FIG. 1A is a horizontal cross-sectional view of a superconducting wire material of this embodiment, FIG. 1B is a partial enlarged cross-sectional view of the same superconducting wire material, and FIG. 1C is a partial perspective view of the same superconducting wire material.
In the superconducting wire material A (and A1) of this embodiment, an intermediate layer 2, a superconducting layer 3, and a metal stabilizing layer 4 are laminated on a base material 1 in order. A plurality of grooves 20 extending along the long direction of the base material 1 are formed in parallel across the width direction of the base material 1 in the metal stabilizing layer 4 and the superconducting layer 3, such that the intermediate layer 2 are exposed. A plurality of filament conductors 10 which are divided by the grooves 20 are arranged at predetermined intervals across the width direction of the base material 1.

The base material 1 need only be useable as a base material for a normal superconducting wire material, and is preferably shaped like an elongated plate or a sheet, and is preferably made form a heat-resistant metal. Among heat-resistant metals, alloys are preferable, and nickel (Ni) alloy and copper (Cu) alloy are preferable. A suitable commercial marketed product is Hastelloy (Registered Trademark, Haynes International Inc.), any type of which can be used, such as Hastelloy B, C, G, N, and W, which have different quantities of molybdenum (Mo), chromium (Cr), iron (Fe), cobalt (Co), etc.

The thickness of the base material 1 can be adjusted as appropriate to the intended purpose; normally, preferably in the range of 10 µm to 500 µm, and more preferably in the range of 20 µm to 200 µm. When the thickness is equal to or more than 10 µm, the superconducting wire material A becomes stronger, and when it is equal to or less than 500 µm, the critical current density of the superconducting wire material A is enhanced.

The intermediate layer 2 controls the crystal orientation of the superconducting layer 3, and prevents the diffusion of metal elements in the base material 1 to the superconducting layer 3. The intermediate layer 2 also functions as a buffer layer for alleviating differences in the physical characteristics (thermal expansion coefficient, lattice constant, etc.) between the base material 1 and the superconducting layer 3. A metal oxide having physical characteristics with values between those of the base material 1 and the superconducting layer 3 is preferably used as the material for this intermediate layer 2. Specific examples of materials that are preferably used as the intermediate layer 2 include metal oxides such as Gd₂Zr₂O₇, MgO, ZrO₂―Y₂O₃ (YSZ), SrTiO₃, CeO₂, Y₂O₃, Al₂O₃, Gd₂O₃, Zr₂O₃, Ho₂O₃, and Nd₂O₃.

The intermediate layer 2 can be a single layer or a plurality of layers. For example, a layer made the metal oxide (metal oxide layer) of the intermediate layer 2 preferably has crystal orientation, and, when there is a plurality of layers, it is preferable that at least the outermost layer (the layer nearest the superconducting layer 3) has crystal orientation.

The intermediate layer 2 can have a multi-layer structure wherein a gap layer is further laminated on the metal oxide layer. The gap layer has the functions of controlling the orientation of the superconducting layer 3. The gap layer also has functions such as suppressing diffusion of the elements constituting the superconducting layer 3 to the intermediate layer 2, and suppressing a reaction between the intermediate layer 2 and the gas used in laminating the superconducting layer 3. The orientation of the gap layer is controlled by the metal oxide layer.

The gap layer is preferably formed by the steps of epitaxial growth on a surface of the metal oxide layer, then grain growth (overgrowth) in the horizontal direction (planar direction), and selective growth of crystal grains in the in-plane direction. The gap layer thereby obtained has higher a degree of in-plane orientation than the metal oxide layer.
While there are no particular restrictions on the material for the gap layer, which need only be capable of fulfilling the functions mentioned above, specific examples of suitable materials include CeO₂, Y₂O₃, Al₂O₃, Gd₂O₃, Zr₂O₃, Ho₂O₃, and Nd₂O₃. When the gap layer is made from CeO₂, the gap layer can contain a Ce―M―O based oxide in which the Ce part has been replaced with another metal atom or metal ion.

While the thickness of the intermediate layer 2 can be adjusted as appropriate to the intended purpose, it is normally in the range of 0.1 µm to 5 µm.
When the intermediate layer 2 has a multi-layered structure wherein a gap layer is laminated on the metal oxide layer, the thickness of the gap layer is normally in the range of 0.1 µm to 1.5 µm.

The intermediate layer 2 can be laminated by a conventional method of forming an oxide thin-film, such as by a physical deposition method such as sputtering, vacuum deposition, laser deposition, electronic beam deposition, ion beam assisted deposition (hereinafter abbreviated as IBAD method), and chemical vapor deposition (CVD); by metal organic deposition (MOD method); or by thermal spraying. A metal oxide layer formed by IBAD method is particularly preferable, since it has high crystal orientation and is effective in controlling the crystal orientation of the superconducting layer 3 and the gap layer. IBAD method is a method where, during deposition, the crystal axis is oriented by irradiating an ion beam at a predetermined angle to the crystal deposition face. Normally, an argon (Ar) ion beam is used as the ion beam. For example, an intermediate layer 2 formed from Gd₂Zr₂O₇, MgO or ZrO₂―Y₂O₃ (YSZ) is particularly favorable in that it can reduce the value of ΔΦ (FWHM: full-width half-maximum), which is an indicator of the degree of orientation in IBAD method.

A superconducting layer made from a superconductor with a conventionally known composition can be broadly applied as the superconducting layer 3, a superconducting layer made from an oxide superconductor being preferable. Specifically, a material of REBa₂Cu₃O_{y} (RE representing a rare earth element such as Y, La, Nd, Sm, Er, Gd, etc.) can be used.
The superconducting layer 13 can be laminated by a physical deposition method such as sputtering, vacuum deposition, laser deposition, electronic beam deposition, and chemical vapor deposition (CVD method), or by metal organic deposition (MOD method); of these, laser deposition is preferable.
The thickness of the superconducting layer 13 is, for example, in the range of 0.5 µm to 9 µm.

The metal stabilizing layer 4 is a main constituent element that becomes conductive when one part of the superconducting layer 3 has reached a state of normal conduction, thereby stabilizing the superconducting layer 3 and preventing the superconducting layer 3 being burnout.
The metal stabilizing layer 4 is preferably made of a metal with good electrical conductivity; specific examples are silver or a silver alloy.
The metal stabilizing layer 4 can be laminated using a known method, preferably sputtering. An oxygen heat process is preferably performed at the final step of forming the metal stabilizing layer 4.
The thickness of the metal stabilizing layer 4 is, for example, in the range of 3 µm to 10 µm.

In the superconducting wire material A1 of the embodiment shown in FIG. 1B, grooves 20 are formed in the superconducting layer 3 and the metal stabilizing layer 4 along the long direction of the base material 1 from the metal stabilizing layer 4 to the intermediate layer 2 (the surface thereof), exposing the intermediate layer 2. The grooves 20 divide the superconducting layer 3 and the metal stabilizing layer 4 into three filament conductors 10, 10, and 10 in the width direction of the base material 1.
The widths W31, W32, and W33 of the three superconducting layers 3 divided by the grooves 20 in the width direction of the base material 1 can be the same or they can be different from each other; normally they are almost the same. Also, the widths d1 and d1 of the grooves 20 dividing the superconducting layers 3 can be the same or they can be different from each other; normally they are almost the same. The width d1 of the grooves at the lower part of the superconducting layer 3 is preferably in the range of 10 µm to 500 µm, and more preferably in the range of 100 µm to 250 µm.
The widths W41, W42, and W43 of the three metal stabilizing layers 4 divided by the grooves 20 in the width direction of the base material 1 can be the same or they can be different from each other; normally they are almost the same. Also, the widths d2 and d2 of the grooves 20 dividing the metal stabilizing layers 4 at the lower parts of the metal stabilizing layers 4 can be the same or they can be different from each other; normally they are almost the same.
The width d1 of the grooves at the lower part of the superconducting layers 3 and the width d2 of the grooves at the lower part of the metal stabilizing layers 4 are substantially similar. Preferably, the difference δd (d1―d2) between the width d1 of the grooves at the lower part of the superconducting layers 3 and the width d2 of the grooves at the lower part of the metal stabilizing layers 4 is not more than 10 µm.

Thus, the grooves 20 are formed together in the metal stabilizing layer 4 and the superconducting layer 3 along the long direction of the base material 1, dividing and thinning the superconducting layers 3, and thereby reducing the AC-loss of the superconducting wire material A1.
In the superconducting wire material A1 of this embodiment, the filament resistance per 1 cm length between the superconducting layers 3 divided by the grooves 20 into a plurality of filament conductors 10 is preferably not less than 10⁵ Ω/cm, and more preferably not less than 10⁶ Ω/cm.

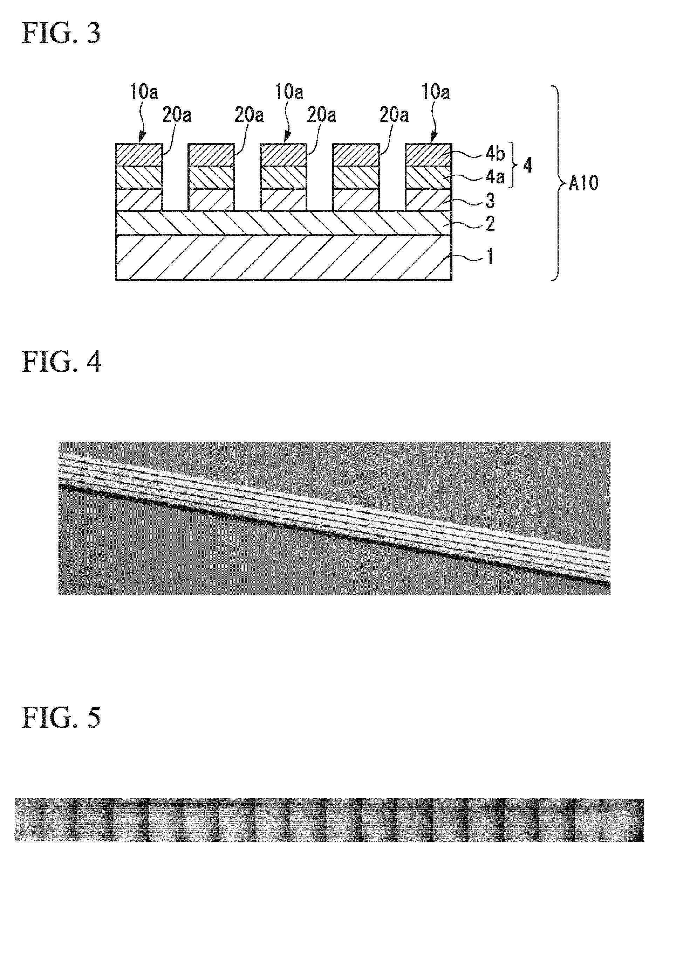

FIG. 3 shows a superconducting wire material A10 of a second embodiment of the invention. As shown in this example, the metal stabilizing layer 4 can be structured such that a second metal stabilizing layer 4b is laminated on a first metal stabilizing layer 4a.
The first metal stabilizing layer 4a stabilizes the superconducting layer 3, and can be the same compound, formed by the same method, and at the same thickness as in the example of the metal stabilizing layer 4 in the first embodiment described above.

While the second metal stabilizing layer 4b stabilizes the superconducting layer 3 in the same manner as the first metal stabilizing layer 4a, it need not have the same electrical conductivity as the first metal stabilizing layer 4a. Preferable materials for the second metal stabilizing layer 4b include anyone of copper (Cu), nickel (Ni) alloys such as copper-nickel (Cu―Ni) alloy and nickel-chrome (Ni―Cr) alloy, stainless steel, silver alloy, etc. By forming the second metal stabilizing layer 4b from a material that is less expensive than the first metal stabilizing layer 4a, a superconducting layer with a strong stabilizing effect can be obtained at low cost.

In the superconducting wire material A10 of the second embodiment shown in FIG. 3, as in the first embodiment, grooves 20a are formed in the metal stabilizing layer 4 including the first metal stabilizing layer 4a and the second metal stabilizing layer 4b and the superconducting layer 3, in which the grooves 20 extending along the long direction of the base material 1, and reach the (surface of the) intermediate layer 2 from the metal stabilizing layer 4 to expose the intermediate layer 2. These grooves 20a divide the superconducting layer 3 and the metal stabilizing layer 4 into three filament conductors 10a, 10a, and 10a in the width direction of the base material 1. The width and thickness in the base material 1 direction of the three superconducting layers divided by the grooves 20a are preferably the same as in the first embodiment. Also, the width in the width direction of the base material 1 of the metal stabilizing layer 4 including the first metal stabilizing layer 4a and the second metal stabilizing layer 4b, and the groove width at the lower part of the metal stabilizing layer 4, are preferably the same as those of the metal stabilizing layer 4 in the first embodiment. In this embodiment, the groove width at the lower part of the superconducting layer 3 is preferably in the range of 10 µm to 500 µm, and more preferably in the range of 100 µm to 250 µm. The difference between the groove width at the lower part of the superconducting layer 3 and the groove width at the lower part of the metal stabilizing layer 4 is preferably not more than 10 µm.
In the superconducting wire material A10 of this embodiment, the filament resistance per 1 cm length between the superconducting layers 3 divided by the plurality of grooves 20a into a plurality of filament conductors 10a is preferably not less than 10⁵ Ω/cm, and more preferably not less than 10⁶ Ω/cm.

By forming the grooves 20 together along the long direction of the base material 1 in the metal stabilizing layer 4 including the first metal stabilizing layer 4a and the second metal stabilizing layer 4b and the superconducting layer 3, dividing and thinning the superconducting layer 3 in this manner, the AC-loss of the superconducting wire material A 10 is reduced. Furthermore, by forming the second metal stabilizing layer 4b from a material than is less expensive than that of the first metal stabilizing layer 4a, a superconducting layer 3 with a strong stabilizing effect can be obtained at low cost.

The superconducting wire materials A1 and A10 of the embodiments of the invention can be entirely covered with an insulating covering layer (not shown). By covering with the covering layer, the covering layer protects the parts where the grooves are provided, and obtains a superconducting wire material with stable performance.
The covering layer can be made from a known material that is normally used as insulating covering material for superconducting wire material and the like, such as various types of resin or oxide.
Specific examples of this resin include polyimide resin, polyamide resin, epoxy resin, acrylic resin, phenol resin, melamine resin, polyester resin, silicone plastic, silicon resin, alkyd resin, vinyl resin, and the like. Ultraviolet curable resin is preferable.
Examples of oxide that are can be used include CeO₂, Y₂O3, Gd₂Zr₂O₇, Gd₂O₃, ZrO₂―Y₂O₃ (YSZ), Zr₂O₃, Ho₂O₃, and the like.
There are no particular restrictions on the thickness of the covering layer, which can be adjusted as appropriate in accordance with the position of the object being covered, etc.
The covering layer can be formed using a known method in accordance with its material. For example, a raw material can be applied and hardened, or, if a sheet-like material can be obtained, this can be laminated.

The superconducting wire material of the invention is not limited to above description, and its configuration can be partially changed, added, or deleted without hindering the effects of the invention.
For example, there is no particular restriction on the number of grooves formed in the metal stabilizing layer 4 and the superconducting layer 3, which can be adjusted to suit the purpose.

Subsequently, one example of a method for manufacturing a low AC-loss multi-filament superconducting wire material of the invention (hereinafter termed 'a method for manufacturing a superconducting wire material of the invention') will be explained.

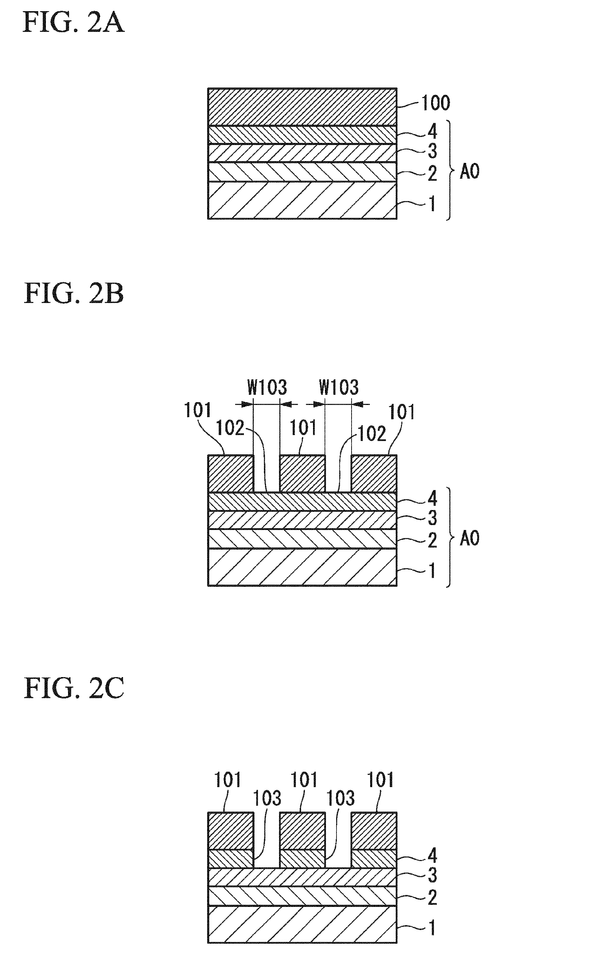

FIGS. 2A to 2E are explanatory schematic views of a method for manufacturing the superconducting wire material A1 of the first embodiment of the invention, being horizontal cross-sectional views of the superconducting wire material A1.
As shown in FIG. 2A, to manufacture the superconducting wire material A1 with the configuration, firstly, an intermediate layer 2, a superconducting layer 3, and a metal stabilizing layer 4 are formed as film in order on the base material 1, obtaining a laminated body A0.

A masking material 100 is then laminated over the surface of the metal stabilizing layer 4 of the superconducting wire material A0.
The masking material 100 can be laminated by a method such as affixing an adhesive tape, applying varnish, spraying acrylic resin, etc.
There are no particular restrictions on the adhesive tape, which need only be a resin tape with an adhesive agent such as polyester tape, Kapton tape (polyimide tape), polyethylene tape, polypropylene tape, fluorine resin tape, etc. Of these, polyester tape and Kapton tape are preferable, as they are easily obtained as industrial products and can provide an elongated superconducting wire material.
A conventionally know varnish can be used, a preferable example being polyimide or the like. The varnish can be applied using a method such as spraying, a wire-drawing die, a doctor blade, etc.
The thickness of the masking material 100 is preferably in the range of 10 µm to 100 µm, and more preferably in the range of 20 µm to 70 µm. If the masking material 100 has a thickness within this range is used, when forming a masking pattern by laser irradiation as explained below, a pattern with a good shape can be formed without excessively damaging the metal stabilizing layer 4.

The masking material 100 is then irradiated with a laser beam, whereby, as shown in FIG. 2B, a masking pattern is formed by parallelly providing, in the width direction of the base material 1, a plurality of thin linear exposed parts 102 extending along the long direction of the base material 1. When the masking material 100 is irradiated with the laser beam, the irradiated section of the masking material 100 vaporizes, and the metal stabilizing layer 4 is exposed by an exposed part 102 having a width W103 in the width direction of the base material 1 with only slight damage to the metal stabilizing layer 4. The section of the masking material 100 that was not irradiated with the laser remains on the surface of the metal stabilizing layer 4 as a masking part 101.
The widths W103 of the exposed parts 102 of the metal stabilizing layer 4 exposed from the masking material 100 can be the same or they can be different from each other; normally they are roughly the same. The widths W103 of the exposed parts 102 are preferably substantially similar to the widths d1 and d2 of the grooves 20 formed in the metal stabilizing layer 4 and the superconducting layer 3; specifically, they are preferably in the range of 10 µm to 500 µm, and more preferably in the range of 100 µm to 250 µm.

The widths W103 of the exposed parts 102 can be controlled by adjusting laser irradiation intensity, the laser spot diameter, and the working speed, i.e. the traveling speed of the superconducting wire material. There are no particular restrictions on the type (wavelength) of the laser light source and the laser irradiation output, which can be, for example, 1 W to 10W. The laser spot diameter can be, for example, in the range of 10 µm to 200 µm. The traveling speed of the superconducting wire material need only be set as appropriate in consideration of the irradiation output of the laser such as to achieve the desired widths W103 of the exposed parts 102, e.g. in the range of 1 mm/s to 20 mm/s.
While irradiating the masking material 100 with the laser beam, there are no particular restrictions on the irradiation angle of the laser beam with respect to the horizontal direction of the base material 1, and the laser beam can be irradiated from a perpendicular direction, or at an inclination of, for example, 45 degrees from the direction perpendicular to the base material 1.

The laminated body A0 with a masking pattern formed in this manner is placed in a continuous etching device or the like (not shown), and the sections of the metal stabilizing layer 4 that are not covered with the masking part 101 (the sections exposed by the exposed parts 102) are etched by corrosion with a strong alkaline solution to form first grooves 103 (FIG. 2C). While any conventionally known strong alkaline solution can be used as the strong alkaline solution for corroding the metal stabilizing layer 4, a preferable example is a mixed solution of hydrogen peroxide water and ammonia water. Preferably, this mixed solution contains 25 wt% to 35 wt% (weight %) water solution of hydrogen peroxide and 28 wt% to 30 wt% (weight %) water solution of ammonia, and more preferably contains 30 wt% to 35 wt% (weight %) water solution of hydrogen peroxide and 28 wt% to 30 wt% (weight %) water solution of ammonia. More specifically, a mixed solution of hydrogen peroxide water (30 wt% to 35 wt%): ammonia water (28 wt% to 30 wt%) = 9:1 to 1:3 (volume ratio) is preferable, and a mixed solution of hydrogen peroxide water (30 wt% to 35 wt%): ammonia water (28 wt% to 30 wt%) = 4:1 1 to 1:1 (volume ratio) is even more preferable. In this case, the weight ratio of the hydrogen peroxide and the ammonia in the mixed solution of hydrogen peroxide water and ammonia water used as the strong alkaline solution is preferably hydrogen peroxide : ammonia = 13:1 to 1:2, and more preferably 5.8:1 to 1.4:1. By using a strong alkaline solution having this composition as the etching solution, the time required to corrode the metal stabilizing layer 4 and form the first grooves 103 by etching is shortened. This improves productivity. Also, this etching solution makes it possible to form the first grooves 103 with the desired shape, without corroding the superconducting layer 3. The processing temperature of the strong alkaline solution in the step of forming the first grooves 103 is preferably in the range of 15°C to 80°C, and more preferably in the range of 20°C to 60°C. The etching time can be adjusted depending on the length of the superconducting wire material and the length of the etching tank. For example, when processing a superconducting wire material with a length of 1 cm and a width of 1 cm including a metal stabilizing layer 4 with a thickness of 20 µm, the etching time is preferably in the range of 10 seconds to 40 seconds, and more preferably in the range of 10 second to 20 seconds. When etching is performed by corroding the metal stabilizing layer 4 with a strong alkaline solution in this manner, the width of the grooves 103 of the metal stabilizing layer 4 in the width direction of the base material 1 can be made almost the same as the widths W103 of the exposed parts 102 in the masking pattern.

When the structure of the metal stabilizing layer 4 is one where the second metal stabilizing layer 4b is laminated on the first metal stabilizing layer 4a as in the superconducting wire material A10 of the second embodiment, if the composition and density of the strong alkaline solution used for etching are selected appropriately, the grooves are formed in two stages. Firstly, the second metal stabilizing layer 4b is corroded to form a groove, and then the first metal stabilizing layer 4a is corroded to form a groove. While the etching solution for the first metal stabilizing layer 4a and the etching solution for the second metal stabilizing layer 4b can be the same or different, it is more preferable to select etching solutions of different compositions and densities as appropriate depending on the types of metal constituting the first metal stabilizing layer 4a and the second metal stabilizing layer 4b, since this enables the etching time to be shortened. As the etching solution that is used, when the first metal stabilizing layer 4a is made of Ag (silver), the mixed solution of hydrogen peroxide water and ammonia water mentioned above is preferable, e.g. a mixed solution of hydrogen peroxide : ammonia = 2:1 (density to water is 30 wt%) can be selected. When the second metal stabilizing layer 4b is made from Cu (copper), it is preferable to use the mixed solution having the same composition of hydrogen peroxide water and ammonia water as the one mentioned above, and an oxidizing agent. As the oxidizing agent, for example, aqueous ferric chloride (5 wt% to 13 wt%) can be selected. There are no particular restrictions on the mixing ratio of the mixed solution of hydrogen peroxide water and ammonia water and the oxidizing agent, which can be, for example, in the range of 1:4 to 4:1. When the oxidizing agent is also used, the etching effect can be enhanced. In this case, for example, the etching temperature of the second metal stabilizing layer 4b is in the range of 15°C to 80°C, and, when etching a superconducting wire material having a length of 1 cm and a width of 1 cm and including a second metal stabilizing layer 4b with a thickness of 10 µm, the time required for etching is in the range of 10 seconds to 15 seconds. The etching temperature of the first metal stabilizing layer 4a is, for example, in the range of 15°C to 90°C, and, when etching a superconducting wire material having a length of 1 cm and a width of 1 cm and including a first metal stabilizing layer 4a with a thickness of 20 µm, the time required for etching can be set at in the range of 10 seconds to 30 seconds. When the etching has ended, the strong alkaline solution and the corroded silver are washed away with running water or the like.

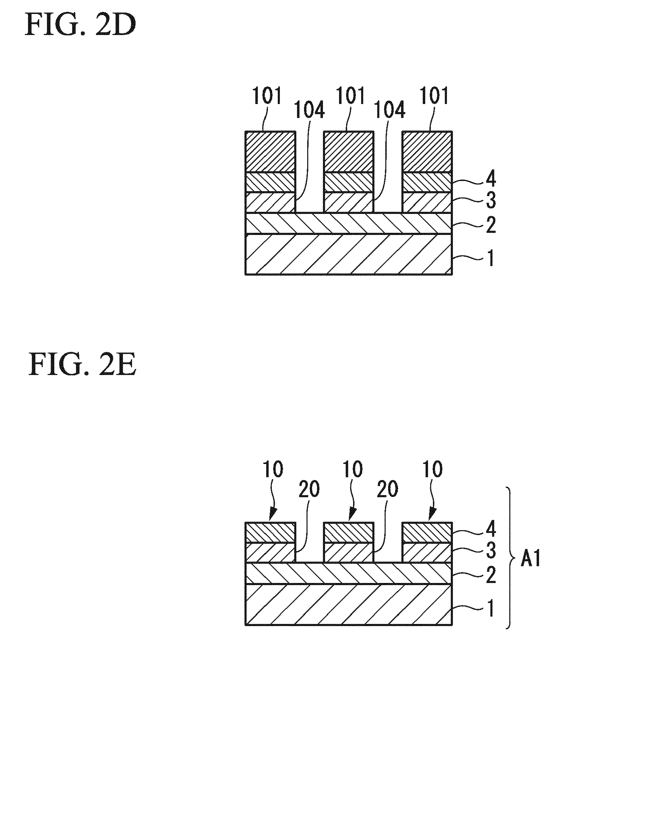

When the first grooves 103 are formed in the metal stabilizing layer 4 in this manner, one part of the superconducting layer 3 is exposed by the first grooves 103 having widths that follow the masking pattern. With the laminated body still in this state where the masking pattern is laminated on the metal stabilizing layer 4, the section of the superconducting layer 3 that was exposed by corroding the metal stabilizing layer 4 is then etched by corroding it with a strong acidic solution, forming second grooves 104 together with the first grooves 103 (FIG. 2D). A conventionally known strong acidic solution can be used as the strong acidic solution for corroding the superconducting layer 3; cerium ammonium nitrate solution is preferable. By using a strong acidic solution of such a composition as the etching solution, the time required to performing etching by corroding the superconducting layer 3 and forming the second grooves 104 can be shorted. This improves productivity.
Conventionally, when using one type of etching solution, there have been cases of excessive removal of the superconducting layer, known as over-etch. However, in the method for manufacturing the multi-filament superconducting wire material of this invention, the etching solution for forming the first grooves 103 and the etching solution for forming the second grooves 104 are each selected appropriately. That is, in the formation process of the first grooves 103, by using a strong alkaline solution, preferably ammonia and hydrogen peroxide water solution, only the metal stabilizing layer 4 is etched without affecting the superconducting layer 3, and in the formation process of the second grooves 104, by using a strong acidic solution, only the superconducting layer 3 is etched without affecting the metal stabilizing layer 4. Over-etching of the superconducting layer 3 can therefore be suppressed, making it possible to ensure that the difference δd (d1―d2) between the width d1 of the grooves at the lower part of the superconducting layers 3 and the width d2 of the grooves at the lower part of the metal stabilizing layers 4 is not more than 10 µm.

The processing temperature for the strong acidic solution in the step of forming the second grooves 104 is preferably in the range of 15°C to 40°C, and more preferably in the range of 15°C to 35°C. As for the processing time using this strong acidic solution, for example, when etching a superconducting wire material with a length of 1 cm and a width of 1 cm including a superconducting layer 3 with a thickness of 20 µm, the processing time is preferably in the range of 5 seconds to 30 seconds, and more preferably in the range of 5 seconds to 20 seconds. When etching is performed by corroding the superconducting layer 3 with a strong acidic solution in this manner, second grooves 104 having almost the same width as the first grooves 103 formed in the metal stabilizing layer 4, more specifically, with the difference δd (d1―d2) between the width d1 of the grooves at the lower part of the superconducting layers 3 and the width d2 of the grooves at the lower part of the metal stabilizing layers 4 being not more than 10 µm, are formed in the superconducting layer 3. Therefore, it is possible to form the second grooves 104 with widths that are almost the same as the width W 103 of the exposed parts 102 of the masking pattern formed in the masking material 100.

After the second grooves 104 have been formed, the unwanted etching solution is washed away with running water or the like, drying is performed using a fan or the like, and the masking pattern 101 is removed (FIG. 2E), whereby the superconducting wire material A 1 of the invention can be manufactured.

In the method for manufacturing a low AC-loss multi-filament superconducting wire material of the invention, the surface of the metal stabilizing layer is masked to form a masking pattern, first grooves are formed in the metal stabilizing layer by corroding with a strong alkaline solution, and second grooves are formed by corroding with a strong acidic solution. Since this enables the superconducting layer to be divided efficiently in a short period of time while removing remnants of Ag or the like, it is possible to provide a method for manufacturing a superconducting wire material that is highly effective in reducing AC-loss at high productivity. Further, according to the manufacturing method of the invention, the etching solution for corroding the metal stabilizing layer and the etching solution for corroding the superconducting layer are each selected appropriately, whereby it becomes possible to form the grooves efficiently in a short period of time, while preventing excessive removal of the superconducting layer known as over-etching. Moreover, since over-etching of the superconducting layer can be suppressed, it is possible to ensure that the difference δd (d1―d2) between the width d1 of the grooves at the lower part of the superconducting layer and the width d2 of the grooves at the lower part of the metal stabilizing layer 4 is not more than 10 µm. It is thus possible to provide a superconducting wire material that suppresses reduction of superconductivity due to excessive removal of the superconducting layer, and is highly effective in reducing AC-loss.

### [Examples]

While specific examples of the invention will be described below, the invention is not limited to these examples.

### (Example 1)

Ion beam assisted deposition (IBAD method) was used to form a film of Gd₂Zr₂O₇ (GZO) with a thickness of 0.5 µm on one face of a substrate made from tape-shaped Hastelloy (Registered Trademark) with a width of 10 mm, and then a film of CeO₂ with a thickness of 1 µm was formed by laser deposition (PLD method). The GZO and the CeO₂ constitute a layer what is known as an intermediate layer or buffer layer, provided between the unoriented metal Hastelloy and the biaxially textured superconducting layer. A superconducting layer of GdBa₂Cu₃O₇ (RE123) with a thickness of 1.5 µm was formed by laser deposition (PLD method) on the intermediate layer, and a metal stabilizing layer of silver with a thickness of 10 µm was formed by sputtering. A superconducting tape wire with a width of 10 mm was cut off by laser cutting at a width of 5 mm to make it easy to use.
The surface of the silver layer (silver stabilizing layer) thus formed was masked by applying an adhesive-fitted polyester tape with a width of 5 mm and a thickness of 25 µm. A position at 840 µm from the end was irradiated with a laser such that the width direction could be divided into five sections with a groove width of 200 µm, and this was deemed a first groove. Laser irradiation (laser output 5W, pulse frequency 10 kHz, laser spot diameter 80 µm) was performed while moving the wire at a speed of 8 mm/s. Given that the groove width is 200 µm, laser irradiation was then performed so that the position of the second groove was within 940 µm from the first groove, i.e.1780 µm from the end. Laser irradiation was similarly performed at positions for third and fourth grooves. A polyester tape was deposited on the sections irradiated with the laser, making a mark with a depth of approximately 10 µm in the silver stabilizing layer.
Using a continuous etching device, the section of the silver stabilizing layer that was irradiated with the laser at room temperature was then corrosively removed in a mixed solution of hydrogen peroxide water (35 wt%) and ammonia water (30 wt%) mixed at a volume ratio of 1:1, and unwanted etching solution was washed away with running water. The time required for etching was 45 seconds. The superconducting layer exposed by the removal of the silver stabilizing layer was corrosively removed at room temperature in a cerium ammonium nitrate solution (30 wt% water solution), and unwanted etching solution was washed away with running water. The time required for etching was 50 seconds. It was then wound around a reel while fan-drying it, and lastly the masking material was removed.
FIG. 4 is an exterior photograph of the laminated body of Hastelloy (Registered Trademark)/GZO/CeO2/RE123/Ag with width of 5 mm that forms a multi-filament superconducting wire material. The average width of the grooves at the lower part of the superconducting layer was 230 µm, and the average width of the grooves at the lower part of the silver stabilizing layer was 220 µm. The resistance between the filaments was not less than 2MΩ per 1 cm length, which ensures good insulation.

### (Example 2)

Ion beam assisted deposition (IBAD method) was used to form a film of Gd₂Zr₂O₇ (GZO) with a thickness of 0.5 µm on one face of a substrate made from tape-shaped Hastelloy (Registered Trademark) with a width of 10 mm, and then a film of CeO₂ with a thickness of 1 µm was formed by laser deposition (PLD method) (formation of intermediate layer). To make it easier to use, it was cut to a width of 4.5 mm using a slitter. A superconducting layer of YBa₂Cu₃O₇ (RE123) with a thickness of 1.2 µm was formed by trifluoroacetate-metalorganic deposition (TFA-MOD method) on the intermediate layer, and a metal stabilizing layer of silver with a thickness of 20 µm was formed on that by sputtering. A superconducting tape wire with a width of 10 mm was cut by laser cutting to a width of 5 mm to make it easy to use.
The surface of the silver layer (silver stabilizing layer) thus formed was masked by applying an adhesive-fitted Kapton tape with a width of 5 mm and a thickness of 12 µm. A location at 1477 µm from the end was irradiated with a laser such that the width direction could be divided into three sections with a groove width of 140 µm, and this was deemed the location of the first groove. Laser irradiation (laser output 4.5W, pulse frequency 10 kHz, laser spot diameter 70 µm) was performed while moving the wire at a speed of 6 mm/s. Given that the groove width is 140 µm, laser irradiation was then performed so that the location of the second groove was within 1547 µm from the first groove, i.e. 3024 µm from the end. Kapton tape was deposited on the sections irradiated with the laser, making a mark with a depth of approximately 10 µm in the silver stabilizing layer.
Using a continuous etching device, the section of the silver stabilizing layer that was irradiated with the laser at room temperature was then corrosively removed in a mixed solution of hydrogen peroxide water (35 wt%) and ammonia water (30 wt%) mixed at a volume ratio of 1:1, and unwanted etching solution was washed away with running water. The time required for etching was 50 seconds. The superconducting layer exposed by the removal of the silver stabilizing layer was corrosively removed at room temperature in a cerium ammonium nitrate solution (30 wt% water solution), and unwanted etching solution was washed away with running water. The time required for etching was 50 seconds. The wire was then wound around a reel while fan-drying it, and lastly the masking material was removed.

The critical current Ic of the multi-filament superconducting wire material of Hastelloy (Registered Trademark)/GZO/CeO₂/RE123/Ag with width of 4.5 mm obtained via these steps was then measured in a zero magnetic field of each filament and at liquid nitrogen temperature. The critical current Ic of filament 1 (the filament divided and formed by the first groove) was 28.8A, the critical current Ic of filament 2 (the filament divided and formed by the first groove and the second groove) was 27.4A, and the critical current Ic of filament 3 (the filament divided and formed by the third groove) was 28.0A. Since the critical current Ic prior to thinning was 95A, the reduction in the critical current Ic was 11%. In AC applications, since the minimum Ic is rate-limiting, a comparison between the minimum Ic x 3 and the Ic prior to thinning gives an actual Ic reduction rate of 14%. Since the groove width here is 140 µm, the area reduction rate is 9%. This area reduction rate means that the deterioration in the Ic due to thinning was only 2%. The resistances between the filaments at a length of 10 cm were 10.5MΩ (between filaments 1 and 2), 5.5MΩ (between filaments 2 and 3), and 4.8 MΩ (between filaments 3 and 1), which indicates good insulation. The average width of the grooves at the lower part of the superconducting layer was 135 µm, and the average width of the grooves at the lower part of the silver stabilizing layer was 140 µm.

### (Example 3)

An unoriented Gd₂Zr₂O₇ (GZO) bed layer with a thickness of 0.1 µm was formed by sputtering on one face of a substrate made from tape-shaped Hastelloy (Registered Trademark) with a width of 10 mm, ion beam assisted deposition (IBAD method) was used to form a biaxially textured film of MgO with a thickness of 0.01 µm, a film of La₂MnO₄ (LMO) with a thickness of 0.1 µm was formed on that, and a film of CeO₂ with a thickness of 0.5 µm was formed on that by laser deposition (PLD method). Here, the layers from GZO bed layer to CeO₂ layer become the intermediate layer. A superconducting layer of GdBa₂Cu₃O₇ (RE123) with a thickness of 1.0 µm was formed on this intermediate layer by laser deposition (PLD method), and a metal stabilizing layer of silver with a thickness of 10 µm was formed on that by sputtering. The superconducting tape wire with a width of 10 mm was cut by laser cutting to a width of 5 mm to make it easy to use. The surface of the silver layer (silver stabilizing layer) thus formed was masked by applying an adhesive-fitted polyester tape with a width of 5 mm and a thickness of 25 µm. A position at 1630 µm from the end was irradiated with a laser such that the width direction could be divided into three sections with a groove width of 220 µm, and this was deemed a first groove. Laser irradiation (laser output 4W, laser frequency 20 kHz, laser spot diameter 80 µm) was performed while moving the wire at a speed of 8 mm/s. Given that the groove width is 220 µm, laser irradiation was then performed so that the position of the second groove was within 1740 µm from the first groove, i.e. 3070 µm from the end. A polyester tape was deposited on the sections irradiated with the laser, making a mark with a depth of approximately 10 µm in the silver stabilizing layer.
Using a continuous etching device, the section of the silver stabilizing layer that was irradiated with the laser at room temperature was then corrosively removed in a mixed solution of hydrogen peroxide water (35 wt%) and ammonia water (30 wt%) mixed at a volume ratio of 2:1, and unwanted etching solution was washed away with running water. The time required for etching was 60 seconds. The superconducting layer exposed by the removal of the silver stabilizing layer was corrosively removed at room temperature in a cerium ammonium nitrate solution (30 wt% water solution), and unwanted etching solution was washed away with running water. The time required for etching was 70 seconds. It was then wound around a reel while fan-drying it, and lastly the masking material was removed.

The critical current Ic of the multi-filament superconducting wire material of Hastelloy (Registered Trademark)/GZO/MgO/LMO/CeO₂/RE123/Ag with width of 5 mm obtained via these steps was then measured in a zero magnetic field of each filament and at liquid nitrogen temperature. The critical current Ic of filament 1 (the filament divided and formed by the first groove) was 54.0A, the critical current Ic of filament 2 (the filament divided and formed by the first groove and the second groove) was 50.5A, and the critical current Ic of filament 3 (the filament divided and formed by the second groove) was 44.0A. Since the critical current Ic prior to thinning was 175A, the Ic reduction was 15%. In AC applications, since the minimum Ic is rate-limiting, a comparison between the minimum Ic x 3 and the Ic prior to thinning gives an actual Ic reduction rate of 25%. Since the groove width here is 220 µm, the area reduction rate is 11.5%. Taking this area reduction rate into consideration, the deterioration in the Ic due to thinning was only 3.6%. The resistances between the filaments at a length of 10 cm were 1.0MΩ (between filaments 1 and 2), 1.6MΩ (between filaments 2 and 3), and 2.1MΩ (between filaments 3 and 1), which indicates good insulation. The average width of the grooves at the lower part of the superconducting layer was 220 µm, and the average width of the grooves at the lower part of the silver stabilizing layer was 225 µm.

### (Example 4)

Ion beam assisted deposition (IBAD method) was used to form a film of Gd₂Zr₂O₇ (GZO) with a thickness of 0.5 µm on one face of a substrate made from tape-shaped Hastelloy (Registered Trademark) with a width of 10 mm, and then a film of CeO₂ with a thickness of 1 µm was formed by laser deposition (PLD method). The GZO and the CeO₂ constitute what is known as an intermediate layer or buffer layer, provided between the unoriented metal Hastelloy and the biaxially textured superconducting layer. A YBa₂Cu₃O₇ (RE123) based superconducting layer with a thickness of 1.5 µm was formed by laser deposition (PLD method) on the intermediate layer, and a metal stabilizing layer of silver with a thickness of 10 µm was formed by sputtering. A superconducting tape wire with a width of 10 mm was cut off by laser cutting at a width of 5 mm to make it easy to use.
The surface of the silver layer (silver stabilizing layer) thus formed was masked by applying an adhesive-fitted polyester tape with a width of 5 mm and a thickness of 25 µm, and then laser irradiation is performed. The silver stabilizing layer and the superconducting layer were divided into 20 sections with approximately equal width by laser irradiation (wire moving speed: 10 mm/s, laser output 4W, pulse frequency 20 kHz, laser spot diameter 60 µm). Using a continuous etching device, the silver stabilizing layer and the superconducting layer were corrosively removed in two stages of etching to obtain a multifilament wire. By using a continuous etching device, a multi-filament wire in which the silver stabilizing layer and the superconducting layer are corrosively removed by two stages etching is obtained. A mixed solution of hydrogen peroxide water (35 wt%) and ammonia water (30 wt%) mixed at a volume ratio of 2:1 was used as the etching solution for the silver stabilizing layer, and the time required for etching was 40 seconds (at room temperature). A cerium ammonium nitrate solution (30 wt%) was used as the etching solution for the superconducting layer, and the time required for etching was 40 seconds (at room temperature). The average width of the grooves at the lower part of the superconducting layer was 85 µm, and the average width of the grooves at the lower part of the silver stabilizing layer was 80 µm.
FIG. 5 is a magnetic flux observation photograph of the laminated body of Hastelloy (Registered Trademark)/GZO/CeO₂/RE123/Ag with the width of 5 mm which forms a multi-filament superconducting wire material. FIG. 5 is a composite of stop-motion photographs taken at 20 mT and 40K while moving the superconducting wire material in the long direction at 10 mm each time. In FIG. 5, the bright locations (white lines) running in the long direction are superconducting sections where there is weak coupling, and the dark locations (black lines) running parallel to the white lines are the grooves. Since etching was performed as far as the superconducting layer, magnetic flux selectively infiltrates along the grooves where there is normal conduction.

### (Example 5: Groove width control test 1)

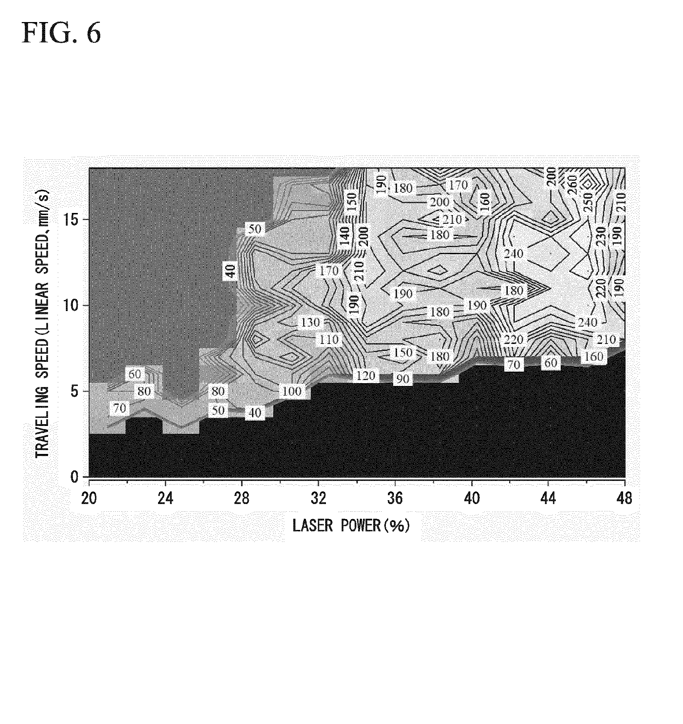

In a Hastelloy (Registered Trademark)/ GZO(IBAD)/CeO₂(PLD) /RE123(PLD)/Ag(Sputtering) wire which is a superconducting wire material having the same configuration as that of Example 1, a UV laser (spot diameter 20µm with an output of 5W and a wavelength of 355 nm was used to form grooves of different widths by changing the laser output and the traveling speed of the wire (linear speed). A polyester adhesive tape with a thickness of 25µm was used as masking material, and the laser output was controlled with an attenuator using a polarizer. FIG. 6 shows the values of groove widths (in units of µm) at the lower part of the superconducting layer formed by forming a masking pattern while changing the laser output and the traveling speed (linear speed) of the base material, and etching a silver stabilizing layer (thickness: 10µm) and a superconducting layer (thickness: 1µm, GdBa₂Cu₃O₇ (RE123)) under the following conditions. In FIG. 6, when, for example, the laser output is 40% (output 2W) and the traveling speed (linear speed) of the base material is 10 mm/s, a width of 190µm can be achieved for the grooves at the lower part of the superconducting layer. The results in FIG. 6 confirm that, due to differences in the laser output and linear speed, it is possible to manufacture a multifilament wire with a groove-width of 40µm to 260µm at the lower part of the superconducting layer.

### (Etching conditions for silver stabilizing layer)

A mixed solution of hydrogen peroxide water (35 wt%) and ammonia water (30 wt%) mixed at a volume ratio of 2:1 was used as the etching solution. The time required for etching was 15 seconds, and the etching temperature was 25°C.

### (Etching conditions for superconducting layer)

A cerium ammonium nitrate water solution (30 wt%) was used as the etching solution. The time required for etching was 15 seconds, and the etching temperature was 25°C.

### (Example 6: Groove width control test 2)

Two types of multifilament wires were compared: one where the metal stabilizing layer and the superconducting layer of a superconducting wire material having the same configuration as that of Example 1 were corrosively removed with different etching solutions, and one where they were corrosively removed using one etching solution. When only one etching solution was used, the etching time required until good insulation (1MΩ per 1 cm) was achieved was 15 minutes. In a cross-sectional observation of the obtained superconducting wire material, over-etching of 200 µm is observed in the superconducting layer. On the other hand, when etching was performed in two stages, the total time required for etching was slightly less than 2 minutes (45 seconds for the first stage and 50 seconds for the second stage). In a cross-sectional observation of the obtained superconducting wire material, over-etching of several µm is observed in the superconducting layer. The etching conditions were as follows.

### (Case where the metal stabilizing layer and the superconducting layer were corrosively removed with different etching solutions:)

### (Etching conditions for metal stabilizing layer)

A mixed solution of hydrogen peroxide water (35 wt%) and ammonia water (30 wt%) mixed at a volume ratio of 2:1 was used as the etching solution. The etching temperature was 25°C.

### (Etching conditions for superconducting layer)

A cerium ammonium nitrate water solution (30 wt%) was used as the etching solution. Etching temperature was 25°C.
(Case where the metal stabilizing layer and the superconducting layer were corrosively etched with only one etching solution:)

Nitric acid water solution (25 wt%) was used as the etching solution. The etching temperature was 25°C.

### (Example 7: Etching time control test)

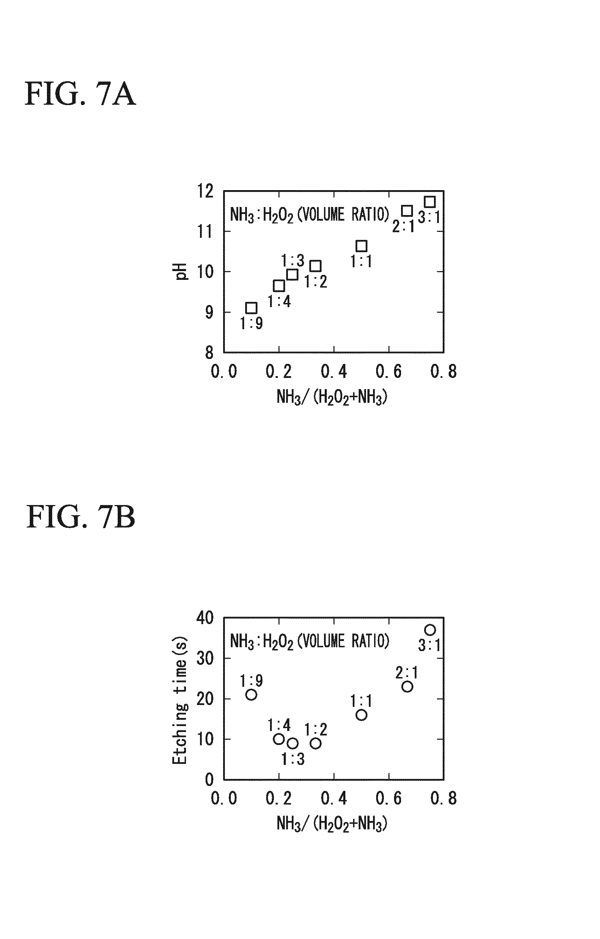

In regard to a wire with a laminated structure of Hastelloy (Registered Trademark)/ GZO(IBAD)/CeO₂(PLD) /RE123(PLD) (RE=Gd)/Ag(Sputtering) with a width of 1 cm and a length of 1cm, when a silver stabilizing layer with a thickness of 20 µm was etched by corrosion in a strong alkaline solution at 25°C, the relationship between the composition of the strong alkaline solution and the etching time was checked. The time to completely erase the silver stabilizing layer without forming a masking pattern was taken as the etching time. As the strong alkaline solutions, uses a mixed solution of hydrogen peroxide water (35 wt%) and ammonia water (30 wt%) mixed at different mixing ratios (volume ratios), and pH of each strong alkaline solution and the time required for etching were plotted. FIGS. 7A and 7B are the results. Table 1 below shows the relationship between NH₃/(H₂O₂+NH₃) (volume ratio) and NH₃: H₂O₂

(volume ratio), which is the mixing ratio of the hydrogen peroxide water and the ammonia water, and NH₃: H₂O₂, (weight ratio) which is the proportion of the hydrogen peroxide and the ammonia in the mixing solution, in FIGS. 7A and 7B.

**[Table 1]**

| NH₃ / (H₂O₂+NH₃) (volume ratio) | NH₃ : H₂O₂ (volume ratio) | NH₃ : H₂O₂ (weight ratio) |
|---|---|---|
| 0.10 | 1 : 9 | 1 : 13.0 |
| 0.20 | 1 : 4 | 1 : 5.8 |
| 0.25 | 1 : 3 | 1 : 4.3 |
| 0.33 | 1 : 2 | 1 : 2.9 |
| 0.50 | 1 : 1 | 1 : 1.4 |
| 0.66 | 2 : 1 | 1.4 : 1 |
| 0.75 | 3 : 1 | 2.0 : 1 |

As shown by the results of FIG. 7A, FIG. 7B, and Table 1, it is possible to control the etching time by adjusting the pH of the strong alkaline solution. Also, the results confirm that is possible to control the etching time by changing the mixing ratio of the ammonia water and the hydrogen peroxide water. That is, it is clear that by setting the mixing ratio of the hydrogen peroxide water (35 wt%) and the ammonia water (30 wt%) at hydrogen peroxide water : ammonia water = 1:3 to 9:1 (volume ratio) (hydrogen peroxide : ammonia = 1:2 to 13:1 (weight ratio)), the etching time can be kept at not more than 40 seconds, and by setting it at hydrogen peroxide water : ammonia water = 1:1 to 4:1 (volume ratio) (hydrogen peroxide : ammonia = 1.4:1 to 5.8:1 (weight ratio)), the etching time can be kept at not more than 20 seconds.

### INDUSTRIAL APPLICABILITY

According to the invention, it is possible to provide a superconducting wire material that is highly effective at reducing AC-loss. It is also possible to manufacture a superconducting wire material that is highly effective at reducing AC-loss with good productivity, and to manufacture a superconducting wire material that can prevent excessive removal of the superconducting layer known as over-etch.

### DESCRIPTION OF THE REFERENCE SYMBOLS

| | |
|---|---|
| 1 | BASE MATERIAL |
| 2 | INTERMEDIATE LAYER |
| 3 | SUPERCONDUCTING LAYER |
| 4 | METAL STABILIZING LAYER |
| 4a | FIRST METAL STABILIZING LAYER |
| 4b | SECOND METAL STABILIZING LAYER |
| 10 | FILAMENT CONDUCTOR |
| 20 | GROOVE |
| 100 | MASKING MATERIAL |
| A, A1, A10 | MULTI-FILAMENT SUPERCONDUCTING WIRE MATERIAL |
| 102 | EXPOSED PART |
| 103 | FIRST GROOVE |
| 104 | SECOND GROOVE |

## Claims

1. A low AC-loss multi-filament superconducting wire material comprising:
an elongated base material;
an intermediate layer formed on the base material;
a superconducting layer formed on the intermediate layer; and
a metal stabilizing layer formed on the superconducting layer, wherein
a plurality of grooves extending along a long direction of the base material is formed in parallel in a width direction of the base material, and reach the intermediate layer from the metal stabilizing layer via the superconducting layer to expose the intermediate layer; and
a difference δd (= d1―d2) between a width d1 of the groove at a lower part of the superconducting layer and a width d2 of the groove at a lower part of the metal stabilizing layer is not more than 10 µm.

2. The low AC-loss multi-filament superconducting wire material according to claim 1, wherein
the width d1 of the groove at the lower part of the superconducting layer is not less than 10 µm and not more than 500 µm.

3. The low AC-loss multi-filament superconducting wire material according to claim 1 or 2, wherein
a resistance between the superconducting layer which is divided into a plurality of filament conductors by the plurality of grooves is not less than 10⁵ Ω/cm.

4. The low AC-loss multi-filament superconducting wire material according to any one of claims 1 to 3, wherein
the metal stabilizing layer is an Ag layer.

5. The low AC-loss multi-filament superconducting wire material according to any one of claims 1 to 3, wherein
the metal stabilizing layer contains an Ag layer, and a Cu layer laminated on the Ag layer.

6. A method for manufacturing a low AC-loss multi-filament superconducting wire material comprising:
laminating an intermediate layer, a superconducting layer, and a metal stabilizing layer in order on an elongated base material;
masking a surface of the metal stabilizing layer to form a masking pattern, and by the masking pattern to provide an exposed part partially exposing the metal stabilizing layer in a plurality of thin lines in parallel in a width direction of the base material along a long direction of the base material;
corroding the exposed part of the metal stabilizing layer in a strong alkaline solution to form first grooves along the long direction of the base material in the metal stabilizing layer, and thereby exposing the superconducting layer; and
corroding the exposed superconducting layer in a strong acidic solution to form second grooves along the long direction of the base material, and thereby exposing the intermediate layer, wherein
a difference δd (= d1―d2) between a width d1 of the second grooves at a lower part of the superconducting layer and a width d2 of the first grooves at a lower part of the metal stabilizing layer is not more than 10 µm.

7. The method for manufacturing a low AC-loss multi-filament superconducting wire material according to claim 6, wherein
the metal stabilizing layer is an Ag layer.

8. The method for manufacturing a low AC-loss multi-filament superconducting wire material according to claim 6, wherein
the metal stabilizing layer contains an Ag layer, and a Cu layer laminated on the Ag layer.

9. The method for manufacturing a low AC-loss multi-filament superconducting wire material according to any one of claims 6 to 8, wherein
the masking is performed by affixing an adhesive tape.

10. The method for manufacturing a low AC-loss multi-filament superconducting wire material according to any one of claims 6 to 8, wherein
the masking is performed by varnish coating or spray coating.

11. The method for manufacturing a low AC-loss multi-filament superconducting wire material according to any one of claims 6 to 8, wherein
the masking is performed by affixing an adhesive tape, and irradiating a surface of the adhesive tape with a laser to form a masking pattern.

12. The method for manufacturing a low AC-loss multi-filament superconducting wire material according to any one of claims 6 to 8, wherein
the masking is performed by laser irradiating a coating surface which has been varnish coated or spray coated, to form a masking pattern.

13. The method for manufacturing a low AC-loss multi-filament superconducting wire material according to any one of claims 6 to 12, wherein
the strong alkaline solution is a mixed solution of hydrogen peroxide water and ammonia water.

14. The method for manufacturing a low AC-loss multi-filament superconducting wire material according to any one of claims 6 to 13, wherein
the strong alkaline solution is a mixed solution of hydrogen peroxide water and ammonia water at a weight ratio of hydrogen peroxide : ammonia = 13:1 1 to 1:2.

15. The method for manufacturing a low AC-loss multi-filament superconducting wire material according to any one of claims 6 to 14, wherein
at least one of a type of the strong alkaline solution and a chemical composition of the strong alkaline solution is adjusted in accordance with a type of metal constituting the metal stabilizing layer.

16. The method for manufacturing a low AC-loss multi-filament superconducting wire material according to any one of claims 6 to 15, wherein
the strong acidic solution is cerium ammonium nitrate solution.

17. The method for manufacturing a low AC-loss multi-filament superconducting wire material according to any one of claims 11 to 16, wherein,
while forming the masking pattern by the laser irradiation, at least one of a processing speed, which is a traveling speed of the superconducting wire material, and a laser irradiation output is adjusted to keep the width of the grooves at the lower part of the superconducting layer not less than 10 µm and not more than 500 µm.
